(19)

Europäisches Patentamt

European Patent Office

Office européen des brevets

(11) **EP 4 583 470 A1**

(12) **EUROPEAN PATENT APPLICATION**
published in accordance with Art. 153(4) EPC

(43) Date of publication:
**09.07.2025   Bulletin 2025/28**

(21) Application number: **22962310.3**

(22) Date of filing: **18.10.2022**

(51) International Patent Classification (IPC):
***H04L 27/00*** *(2006.01)*

(52) Cooperative Patent Classification (CPC):
**H04L 27/00**

(86) International application number:
**PCT/CN2022/125795**

(87) International publication number:
**WO 2024/082114 (25.04.2024 Gazette 2024/17)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Huawei Technologies Co., Ltd.
Shenzhen, Guangdong 518129 (CN)**

(72) Inventors:
• **CHEN, Jinhu
Shenzhen, Guangdong 518129 (CN)**

• **SUO, Hailei
Shenzhen, Guangdong 518129 (CN)**
• **YU, Xueming
Shenzhen, Guangdong 518129 (CN)**
• **SUN, Yijun
Shenzhen, Guangdong 518129 (CN)**
• **ZENG, Zhixiong
Shenzhen, Guangdong 518129 (CN)**
• **SUN, Jie
Shenzhen, Guangdong 518129 (CN)**

(74) Representative: **Gill Jennings & Every LLP
The Broadgate Tower
20 Primrose Street
London EC2A 2ES (GB)**

(54) **POWER AMPLIFIER DEVICE, REMOTE RADIO UNIT, AND BASE STATION**

(57)      This application discloses a power amplifier device, a remote radio unit, and a base station. The power amplifier device is applicable to input of up to three signals, and combines power through hybrid cascading of a coupler and a circulator. The coupler may be used as a last-stage power combination unit, or the circulator may be used as a last-stage power combination unit. The power amplifier device may generate at least three high-efficiency points. Because there are a plurality of high-efficiency points, a problem of an efficiency pit during large backoff can be alleviated, and modulation wave efficiency of a radio frequency power amplifier device can be improved. **In** addition, a working bandwidth of the power amplifier device depends on working bandwidths of a first power amplifier circuit, the coupler, and the circulator, so that an ultra-wideband high-power design can be implemented.

FIG. 2

EP 4 583 470 A1

**Description**

**TECHNICAL FIELD**

This application relates to the field of communication device technologies, and in particular, to a power amplifier device, a remote radio unit, and a base station.

**BACKGROUND**

Currently, a wireless communication system requires a wide bandwidth and high spectral efficiency. For example, a 5G NR (5G New Radio) standard defines an N77 frequency band from 3.3 GHz to 4.2 GHz, that is, a bandwidth of 900 MHz, used for concurrent broadband signals. In addition, a peak-to-average ratio of a high-frequency spectrum signal waveform of the 5G NR is still up to 9 dB even if a crest factor reduction (CFR, Crest Factor Reduction) peak clipping technology is used. A high peak-to-average power ratio (PAPR, Peak-to-Average Power Ratio) and a wide instantaneous bandwidth bring new challenges to a power amplifier (PA, Power Amplifier) of a base station.

Therefore, with development of the wireless communication system, the power amplifier of the base station needs to satisfy high efficiency while implementing an ultra-wideband feature.

**SUMMARY**

To resolve the foregoing technical problems, this application provides a power amplifier device, a remote radio unit, and a base station, to satisfy high efficiency while implementing an ultra-wideband feature.

This application provides a power amplifier device. In addition to the following three power amplifier circuits: a first power amplifier circuit, a second power amplifier circuit, and a third power amplifier circuit, the power amplifier device further includes a first coupler and a circulator. The circulator is used as a last-stage power combination unit. Input ends of the first power amplifier circuit, the second power amplifier circuit, and the third power amplifier circuit input a first signal, a second signal, and a third signal respectively. Both an output end of the first power amplifier circuit and an output end of the second power amplifier circuit are connected to an input port of the first coupler, and the first coupler outputs a signal obtained through power combination. An output port of the first coupler and an output end of the third power amplifier circuit are connected to the circulator, and the circulator combines power of a signal output by the third power amplifier circuit and the signal output by the first coupler, and then outputs a signal obtained through power combination.

The power amplifier device provided in this application is applicable to input of up to three signals, and combines power through hybrid cascading of the coupler and the circulator. The coupler may be used as a last-stage power combination unit, or the circulator may be used as a last-stage power combination unit. The power amplifier device may generate at least three high-efficiency points. Because there are a plurality of high-efficiency points, a problem of an efficiency pit during large backoff can be alleviated, and modulation wave efficiency of a radio frequency power amplifier device can be improved. In addition, a working bandwidth of the power amplifier device depends on working bandwidths of the first power amplifier circuit, the coupler, and the circulator, so that an ultra-wideband high-power design can be implemented. Moreover, the last-stage power combination unit of the power amplifier is implemented by the circulator. The circulator is more suitable for a scenario of a large power capacity. Therefore, the power amplifier is applicable to a large-power ultra-wideband scenario.

This application further provides a power amplifier device. In addition to the following three power amplifier circuits: a first power amplifier circuit, a second power amplifier circuit, and a third power amplifier circuit, the power amplifier device further includes a first coupler and a circulator. The coupler is used as a last-stage power combination unit. Input ends of the first power amplifier circuit, the second power amplifier circuit, and the third power amplifier circuit input a first signal, a second signal, and a third signal respectively. Both an output end of the first power amplifier circuit and an output end of the second power amplifier circuit are connected to the circulator, and the circulator is configured to output a signal obtained through power combination. An output port of the circulator and an output end of the third power amplifier circuit are connected to the first coupler, and the first coupler is configured to: combine power of a signal output by the third power amplifier circuit and the signal output by the circulator, and then output a signal obtained through power combination.

Characteristic impedance of the circulator is not specifically limited in this application, for example, may be 50 ohms.

An implementation form of the first power amplifier circuit is not specifically limited in this application. The first power amplifier circuit may be a single-transistor power amplifier, or may be an integrated power amplifier. For example, the first power amplifier circuit may include any one of the following: a single-transistor power amplifier, a Doherty power amplifier, a Chireix power amplifier, a load modulated balanced amplifier (LMBA, Load Modulated Balanced Amplifier), or a circulator load modulated amplifier (CLMA, Circulator Load Modulated Amplifier) power amplifier.

The second power amplifier circuit includes a first amplification branch and a second amplification branch, and the third power amplifier circuit includes a third amplification branch. The first amplification branch and the second amplification branch are the same, and are both biased in shallow class C. The third amplification branch is biased in deep class C. For example, the first amplification branch, the second amplification branch, and the third amplification branch may all be peak power amplifiers, which are briefly referred to as Peak.

The following uses an example in which the first power amplifier circuit is a single-transistor power amplifier for description. The single-transistor power amplifier is a carrier power amplifier when biased in class AB or class B, and is briefly referred to as Main. The power amplifier device further includes a second coupler and a matching circuit. An input end of the carrier power amplifier is configured to input the first signal, and an output end of the carrier power amplifier is connected to an isolation port of the first coupler. A first input port of the second coupler is configured to input the second signal, and a second input port of the second coupler is connected to a load. The first input port of the second coupler is configured to connect to the second signal, and the second input port of the second coupler is configured to connect to the load. Two output ports of the second coupler are respectively connected to an input end of the first amplification branch and an input end of the second amplification branch, and an output end of the first amplification branch and an output end of the second amplification branch are respectively connected to two balanced ports of the first coupler. The output port of the first coupler is connected to a first end of the matching circuit, and a second end of the matching circuit is connected to an isolation port of the circulator. An input end of the third amplification branch is configured to input the third signal, an output end of the third amplification branch is connected to an input port of the circulator, and an output port of the circulator is configured to output a signal obtained by combining power of signals of the isolation port and the input port.

A load-pull ratio of the first power amplifier circuit is 1. In other words, load of the first power amplifier circuit is unchanged with a change in power of the power amplifier device. Therefore, a working bandwidth of the power amplifier device depends only on a working bandwidth of the single-transistor power amplifier and working bandwidths of the coupler and the circulator, and ultra-wideband can be implemented through a design. In addition, the power amplifier has three high-efficiency points, so that a problem of a large pit during power backoff can be alleviated. Moreover, the last-stage power combination unit of the power amplifier is implemented by the circulator. The circulator is more suitable for a scenario of a large power capacity. Therefore, the power amplifier is applicable to a large-power ultra-wideband scenario.

To implement miniaturization of the power amplifier, the coupler may be designed by using an integrated passive device. The circulator may be a three-port design. In addition, the circulator may be designed, together with an isolator connected to the output port, as a four-port circulator.

The power amplifier device provided in this application may alternatively input two signals. In addition to the foregoing included components, the power amplifier device further includes a first power division circuit and a first phase compensation network. The first power division circuit is configured to output the first signal and the second signal, one end that is of the first power division circuit and that outputs the first signal is connected to an input end of the first phase compensation network, an output end of the first phase compensation network is connected to the input end of the carrier power amplifier, and one end that is of the first power division circuit and that outputs the second signal is connected to the first input port of the second coupler.

The power amplifier device provided in this application may alternatively input one signal. In addition to the foregoing included components, the power amplifier device further includes a second power division circuit and a second phase compensation network. Two output ends of the second power division circuit are respectively connected to an input end of the first power division circuit and an input end of the second phase compensation network. An output end of the second phase compensation network is connected to the input end of the third amplification branch.

The first power amplifier circuit is a single-transistor power amplifier, and the single-transistor power amplifier is a carrier power amplifier when biased in class AB or class B. The second power amplifier circuit includes a fourth amplification branch, and the third power amplifier circuit includes a fifth amplification branch and a sixth amplification branch. The fourth amplification branch is biased in shallow class C, the fifth amplification branch and the sixth amplification branch are the same, and are both biased in deep class C.

The following describes a specific implementation in which the circulator is used as the last-stage power combination unit. The power amplifier device further includes a second coupler, a first matching circuit, and a second matching circuit. The input end of the first power amplifier circuit is configured to input the first signal, and the output end of the first power amplifier circuit is connected to an isolation port of the circulator. An input end of the fourth amplification branch is configured to connect to the second signal, an output end of the fourth amplification branch is connected to an input port of the circulator, an output port of the circulator is connected to a first end of the first matching circuit, and a second end of the first matching circuit is connected to an isolation port of the first coupler. A first input port of the second coupler is configured to input the third signal, and a second input port of the second coupler is connected to a load. The first input port of the second coupler is configured to connect to the third signal, and the second input port of the second coupler is configured to connect to the load. An input end of the fifth amplification branch and an input end of the sixth amplification branch are respectively connected to two output ports of the second coupler, and an output end of the fifth amplification branch and an output end of the sixth amplification branch are respectively connected to two balanced ports of the first coupler. An output port of the first coupler is connected to a first end of the second matching circuit, and an output end of the second matching circuit is configured to output a signal obtained through power combination.

In the power amplifier device provided in this application, the first power amplifier circuit works first, the second power amplifier circuit works later, and the third power amplifier circuit works last. The first power amplifier circuit reaches saturation first, then the second power amplifier circuit reaches saturation, and finally the third power amplifier circuit reaches saturation.

Based on the power amplifier device provided above, this application further provides a remote radio unit, including the power amplifier device described above, and further including a duplexer. One end of the power amplifier device is connected to the duplexer, and the duplexer can send and receive a radio frequency signal.

Based on the remote radio unit provided above, this application further provides a base station, including the remote radio unit described above, and further including an antenna. The remote radio unit is connected to the antenna, and the remote radio unit is configured to process a transmitted/received signal of the antenna.

## BRIEF DESCRIPTION OF DRAWINGS

FIG. 1 is a schematic of a remote radio unit RRU;
FIG. 2 is a schematic of a power amplifier device according to an embodiment of this application;
FIG. 3 is a diagram of a current of a power amplifier device according to an embodiment of this application;
FIG. 4 is a diagram of a voltage of a power amplifier device according to an embodiment of this application;
FIG. 5 is a diagram of impedance of a power amplifier device according to an embodiment of this application;
FIG. 6 is a diagram of an efficiency curve corresponding to FIG. 2 according to an embodiment of this application;
FIG. 7 is a schematic of a power amplifier corresponding to two signals according to an embodiment of this application;
FIG. 8 is a schematic of a power amplifier corresponding to one signal according to an embodiment of this application;
FIG. 9 is a diagram of an efficiency curve according to an embodiment of this application;
FIG. 10 is a schematic of another power amplifier device according to an embodiment of this application;
FIG. 11 is a diagram of an efficiency curve corresponding to FIG. 10;
FIG. 12 is a schematic of still another power amplifier device according to an embodiment of this application;
FIG. 13 is a diagram of an efficiency curve corresponding to FIG. 12; and
FIG. 14 is a schematic of a base station according to an embodiment of this application.

## DESCRIPTION OF EMBODIMENTS

The following describes technical solutions in embodiments of this application with reference to accompanying drawings in embodiments of this application.

In the following descriptions, terms such as "first" and "second" are merely intended for a purpose of description, and shall not be understood as an indication or implication of relative importance or an implicit indication of a quantity of indicated technical features. Therefore, a feature limited by "first", "second", or the like may explicitly or implicitly include one or more features. In the descriptions of this application, unless otherwise stated, "a plurality of" means two or more than two.

In this application, unless otherwise clearly specified and limited, a term "connection" should be understood in a broad sense. For example, the "connection" may be a fixed connection, a detachable connection, or an integrated connection, or may be a direct connection or an indirect connection implemented through an intermediate medium. In addition, a term "coupling" may be a manner of implementing an electrical connection for signal transmission. The "coupling" may be a direct electrical connection, or may be an indirect electrical connection through an intermediate medium.

To implement ultra-wideband high-efficiency power amplification on an input signal, this application provides a power amplifier device, which is applicable to input of up to three signals, and combines power through hybrid cascading of a coupler and a circulator, so that three high-efficiency points can be generated, and a problem of an efficiency pit during large backoff can be resolved. The efficiency pit is a trough on an efficiency curve during power backoff. The power amplifier device is applicable to a high-power power amplifier scenario.

To make a person skilled in the art better understand the technical solutions provided in embodiments of this application, the following first describes an application scenario of the technical solutions with reference to the accompanying drawings.

An example in which the power amplifier device provided in embodiments of this application is used in a remote radio unit (RRU, Radio Remote Unit) in a base station is used for description.

The RRU generally includes a plurality of radio frequency modules, and a power amplifier device is an important part of the RRU. A radio signal is amplified by a power amplifier and then is transmitted through an antenna. Because a signal processed by the power amplifier device is a radio frequency signal, the power amplifier device is a radio frequency power amplifier device. Embodiments of this application specifically relate to the power amplifier device inside the RRU. The power amplifier device includes a power amplifier. For ease of description, the power amplifier is briefly referred to as a power amplifier in the following.

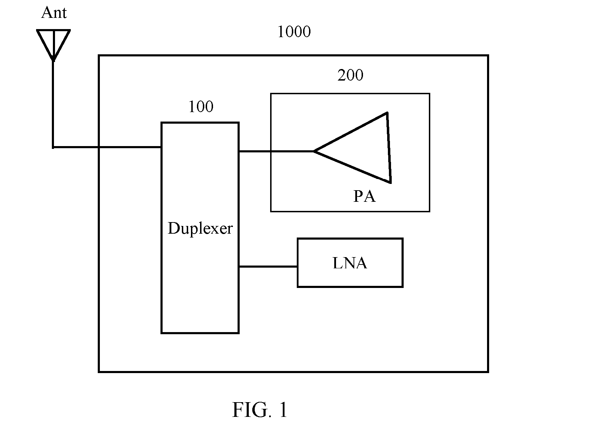

FIG. 1 is a schematic of an RRU.

The RRU 1000 provided in this embodiment of this application may be used in a wireless communication base station. In addition to the RRU 1000, the base station may further include another component, for example, may further include an antenna Ant. Details are not described herein again.

The RRU 1000 includes a power amplifier device 200, a low noise amplifier (LNA, Low Noise Amplifier), and a duplexer 100. The power amplifier device 200 includes a power amplifier PA.

A radio frequency signal amplified by the PA is sent to the antenna Ant through the duplexer 100.

The radio frequency signal received by the antenna Ant is sent to the LNA through the duplexer 100.

According to the power amplifier device 200 provided in this embodiment of this application, a final power combination unit in the power amplifier device may be a coupler or a circulator. The following provides detailed descriptions with reference to the accompanying drawings. First, an implementation in which a final signal is output by the circulator is described.

The power amplifier device provided in this embodiment includes: a first power amplifier circuit, a second power amplifier circuit, a third power amplifier circuit, a coupler, and a circulator. A first signal and a second signal are respectively amplified by the first power amplifier circuit and the second power amplifier circuit and then input to the coupler, and the coupler combines power to obtain a signal for output. A third signal is amplified by the third power amplifier circuit and then output, and the circulator combines power of a signal output by the third power amplifier circuit and the signal output by the coupler and then outputs a signal obtained through power combination.

The first power amplifier circuit works first, the second power amplifier circuit works later, and the third power amplifier circuit works last.

The first power amplifier circuit may be implemented in a plurality of forms. For example, the first power amplifier circuit may include any one of the following: a single-transistor power amplifier, a Doherty power amplifier, a Chireix power amplifier, an LMBA, or a CLMA.

When the first power amplifier circuit is implemented by the single-transistor power amplifier, the single-transistor power amplifier is biased in class AB or class B, may be referred to as a carrier power amplifier, is also referred to as a main power amplifier, and is represented by Main. The following describes implementation in which the first power amplifier circuit is implemented by the single-transistor power amplifier.

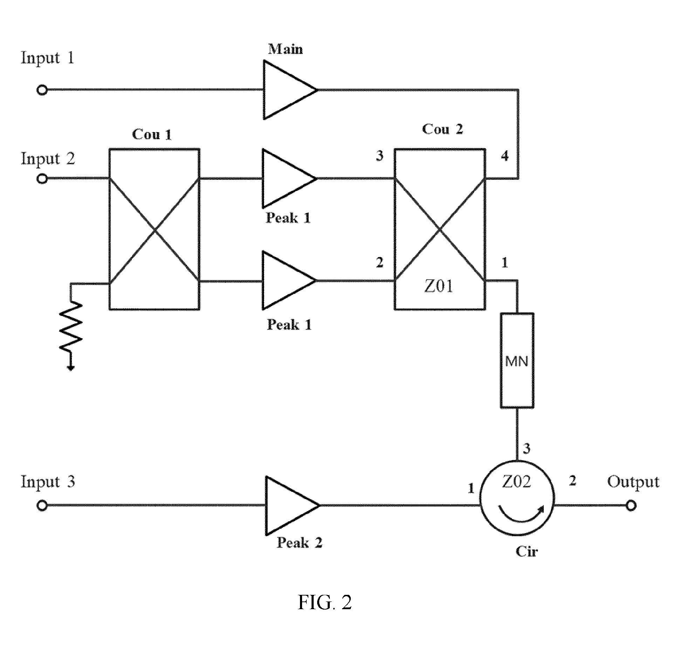

FIG. 2 is a schematic of a power amplifier device according to an embodiment of this application.

The first power amplifier circuit is a single-transistor power amplifier, and is referred to as a carrier power amplifier Main. The carrier power amplifier is also referred to as a main power amplifier.

The second power amplifier circuit includes a first amplification branch and a second amplification branch. The first amplification branch and the second amplification branch are the same, are both biased in shallow class C, and are therefore both represented by Peak 1. It should be understood that the amplification branch provided in this embodiment of this application may include a peak power amplifier, and the peak power amplifier is also referred to as an auxiliary power amplifier.

The third power amplifier circuit includes a third amplification branch, and the third amplification branch is biased in deep class C, and is represented by Peak 2.

As shown in FIG. 2, a first signal Input 1 is input to an input end of the carrier power amplifier Main, and an output end of the carrier power amplifier Main is connected to an isolation port of a first coupler Cou 2.

A second signal Input 2 is input to a first input port of the second coupler Cou 1, and a second input port of the second coupler Cou 1 is connected to a load. Power division is performed on the second signal Input 2 by the second coupler Cou 1, and then divided signals are input to an input end of the first amplification branch Peak 1 and an input end of the second amplification branch Peak 1 respectively. An output end of the first amplification branch Peak 1 and an output end of the second amplification branch Peak 1 are respectively connected to two balanced ports of the first coupler Cou 2.

An output port of the first coupler Cou 2 is connected to an isolation port 3 of a circulator Cir through a matching circuit MN.

A third signal Input 3 is input to an input end of the third amplification branch Peak 2, an output end of the third amplification branch Peak 2 is connected to an input port 1 of the circulator Cir, and an output port 2 of the circulator Cir is configured to output a signal obtained by combining power of signals of the isolation port of the circulator and the input port of the circulator, that is, output a final amplified signal at Output.

Characteristic impedance of the first coupler Cou 2 is Z01. Characteristic impedance of the circulator Cir is Z02. It should be noted that the characteristic impedance Z02 of the circulator is generally 50 ohms (Ohms).

A function of a matching circuit MN is to implement conversion between the impedance Z01 and the impedance Z02, to implement impedance matching between the first coupler Cou 2 and the circulator Cir.

When power of an input signal is low, because Main works in class AB or class B, Main works first, that is, only Main works. After Main reaches saturation, the two Peaks 1 are connected and work. At this time, Peak 2 is still in a disconnected state, and Main remains in a saturated state until the two Peaks 1 reach a saturated state. After Peaks 1 reach saturation, Peak 2 is connected and work. Main and Peaks 1 remain in the saturated state until Main, the two Peaks 1, and Peak 2 all reach saturation.

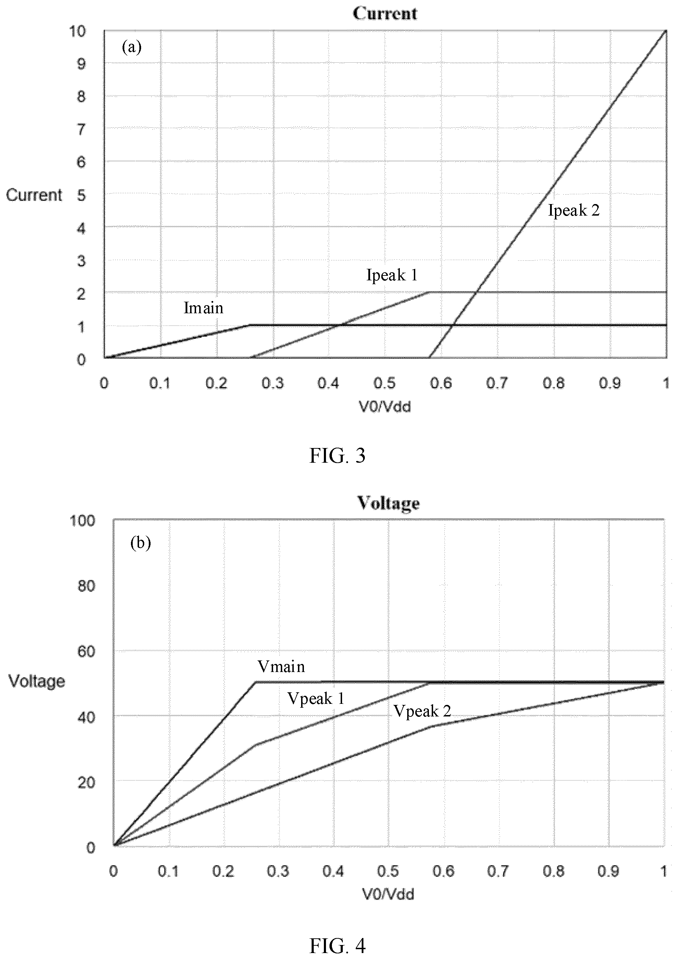

For example, when voltages are normalized at Main:Peak 1:Peak 1:Peak 2=1:2:2:10, for a schematic of currents and a schematic of voltages of Main, the two Peaks 1, and Peak 2, refer to FIG. 3 and FIG. 4 respectively.

Horizontal coordinates in FIG. 3 and FIG. 4 are both a normalized voltage (V0/Vdd), a vertical coordinate in FIG. 3 represents a current (Current), and a vertical coordinate in FIG. 4 represents a voltage (Voltage).

It can be learned from the current diagram shown in FIG. 3 that Main works first, then Peaks 1 work, and Peak 2 works last. In FIG. 3, Imain reaches current saturation earlier than Ipeak 1, and Ipeak 1 reaches current saturation earlier than Ipeak 2.

It can be learned from the voltage diagram shown in FIG. 4 that Main is saturated first, then Peaks 1 are saturated, and finally Peak 2 is saturated. In other words, in FIG. 3, Vmain reaches voltage saturation earlier than Vpeak 1, Vpeak 1 reaches voltage saturation earlier than Vpeak 2, and Vpeak 2 reaches voltage saturation last.

There is no load pull between Main and Peak 1, and there is no load pull between both Main and Peak 1 and Peak 2. A load-pull ratio of Main is 1. Therefore, a working bandwidth of the power amplifier device shown in FIG. 2 depends only on a working bandwidth of the single-transistor power amplifier and working bandwidths of the coupler and the circulator.

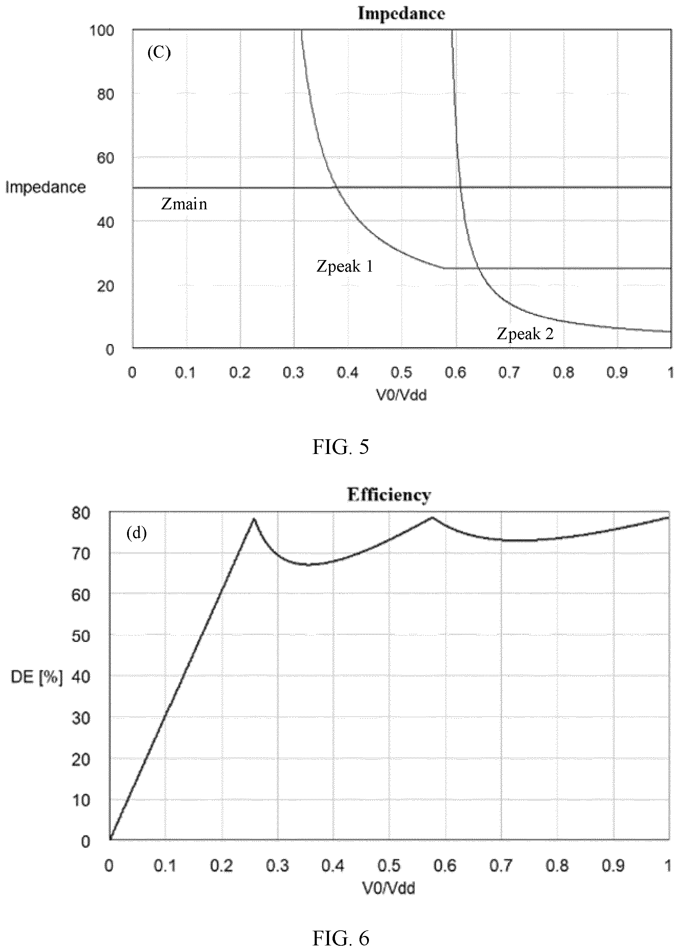

FIG. 5 is a diagram of an impedance relationship between Main, the two Peaks 1, and Peak 2 in a case in which voltages are normalized at Main:Peak 1:Peak 1:Peak 2=1:2:2:10.

A horizontal coordinate in FIG. 5 is a normalized voltage (V0/Vdd), and a vertical coordinate in FIG. 5 represents impedance (Impedance).

It can be learned from FIG. 5 that impedance Zmain of Main remains unchanged, that is, is a straight line parallel to a horizontal axis. Therefore, the load-pull ratio of Main is 1.

The power amplifier device provided in this embodiment of this application can achieve three high-efficiency points. The following provides detailed descriptions with reference to an efficiency curve.

FIG. 6 is a diagram of an efficiency curve corresponding to FIG. 2 according to an embodiment of this application.

The case in which the voltages are normalized at Main:Peak 1:Peak 1:Peak 2=1:2:2:10 is still used for description in FIG. 6. A horizontal coordinate in FIG. 6 is a normalized voltage (V0/Vdd), and a vertical coordinate in FIG. 6 represents efficiency (DE, Efficiency).

Main reaches saturation at a first high-efficiency point. Peaks 1 reach saturation at a second high-efficiency point. Main, Peaks 1, and Peak 2 all reach in a saturated state at a third high-efficiency point. Therefore, the power amplifier provided in this embodiment of this application may generate three high-efficiency points.

The power amplifier device provided in this embodiment of this application is in an LMBA working state between the first high-efficiency point and the second high-efficiency point, and is in a CLMA working state between the second high-efficiency point and the third high-efficiency point.

In the power amplifier device provided in this embodiment, because the load-pull ratio of Main is 1, a bandwidth of the power amplifier is related to Main, the coupler, and the circulator, and ultra-wideband can be implemented through a design. In addition, the power amplifier device has three high-efficiency points, so that a problem of a large pit during power backoff can be alleviated. Moreover, a last-stage power combination unit of the power amplifier device is implemented by the circulator. The circulator is more suitable for a scenario of a large power capacity. Therefore, the power amplifier device is applicable to a large-power ultra-wideband scenario.

The characteristic impedance of the foregoing coupler and circulator may be set according to an actual requirement. For example, when the impedance of the circulator is not 50 ohms, to achieve effect of 50 ohms, an impedance conversion network in which Z02 is 50 ohms may be added at the output end Output as required.

In addition, to implement miniaturization of the power amplifier, the coupler may be designed by using an integrated passive device (IPD, Integrated Passive Device).

The circulator shown in FIG. 2 is a three-port design.

The circulator may be designed, together with an isolator connected to Output, as a four-port circulator.

The power amplifier device is described in FIG. 2 by using an example in which three signals are input to the power amplifier. It should be understood that the power amplifier device provided in this embodiment of this application may also be used in a scenario in which one signal is input or two signals are input. The following provides detailed descriptions with reference to the accompanying drawings.

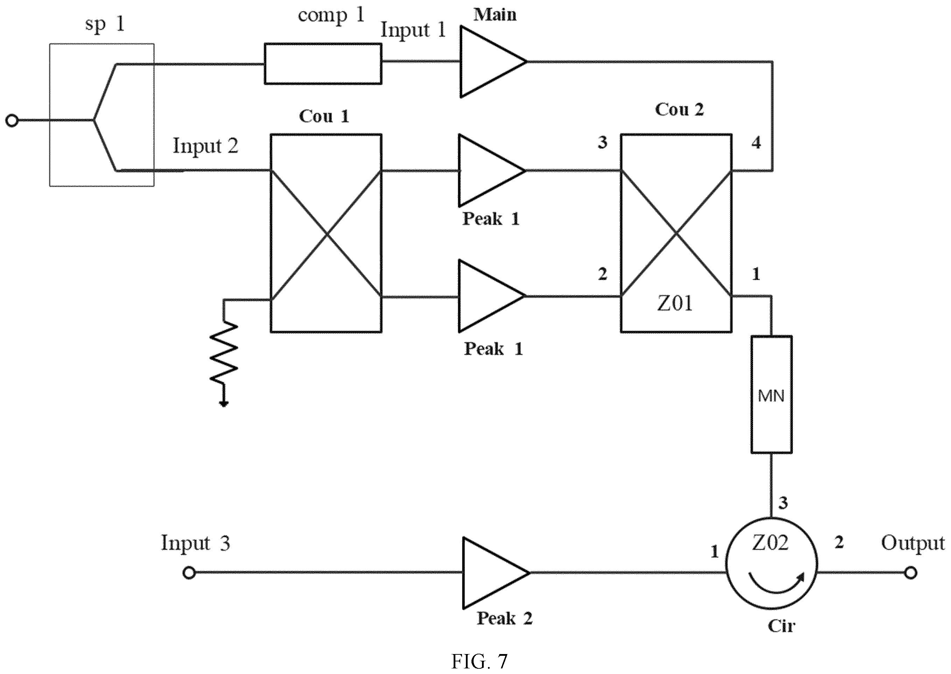

FIG. 7 is a schematic of a power amplifier device corresponding to two signals according to an embodiment of this application.

An input end of the power amplifier device provided in this embodiment may be connected to two signals. It can be learned by comparing FIG. 2 with FIG. 7 that, in addition to the components in FIG. 2, FIG. 7 further includes a first power division circuit Sp 1 and a first phase compensation network Comp 1.

The first signal and the second signal in FIG. 2 may be considered as two signals obtained through power division by the first power division circuit Sp 1, and the first signal is connected to an input end of a carrier power amplifier Main through the first phase compensation network Comp 1.

A function of the first phase compensation network Comp 1 is to implement phase compensation.

It can be learned that, to amplify power of two input signals, in the power amplifier device provided in this embodiment of this application, the first power division circuit Sp 1 and the first phase compensation network Comp 1 are added on a basis of FIG. 2.

In addition, the power amplifier device provided in this embodiment of this application may be further used in a scenario in which a single signal is input. A second power division circuit and a second phase compensation network are further added on a basis of FIG. 7, so that power of a single input signal can be amplified.

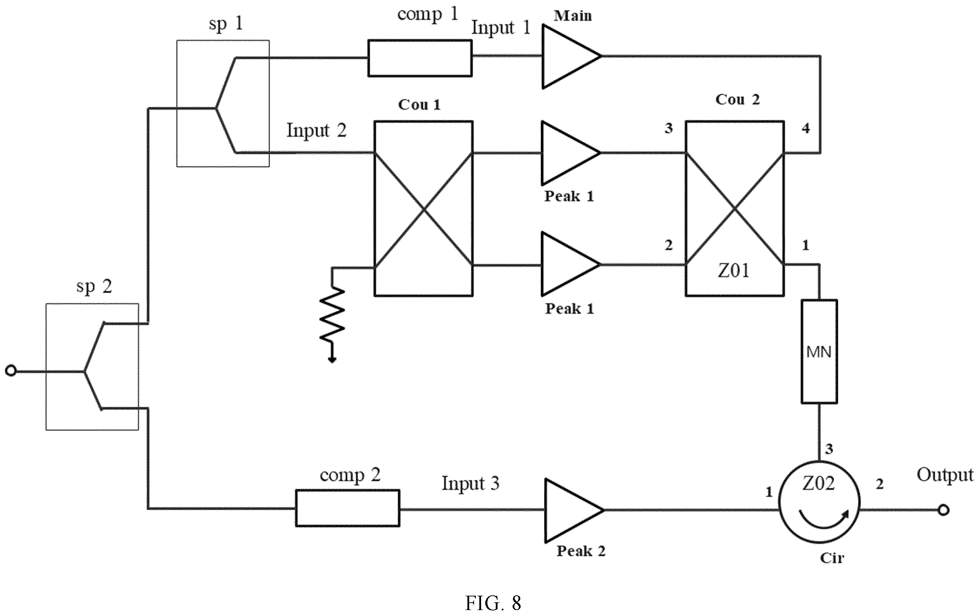

FIG. 8 is a schematic of a power amplifier device corresponding to one signal according to an embodiment of this application.

It can be learned by comparing FIG. 7 with FIG. 8 that, in addition to the components in FIG. 7, the power amplifier device in FIG. 8 further includes a second power division circuit Sp 2 and a second phase compensation network Comp 2.

A third signal is connected to an input end of a third amplification branch Peak 2 through the second phase compensation network Comp 2.

The third signal and an input signal of a first power division circuit Sp 1 are two signals obtained through power division by the second power division circuit Sp 2.

To fully understand high efficiency and a backoff amount of the power amplifier device provided in embodiments of this application, the following provides detailed descriptions with reference to the accompanying drawings.

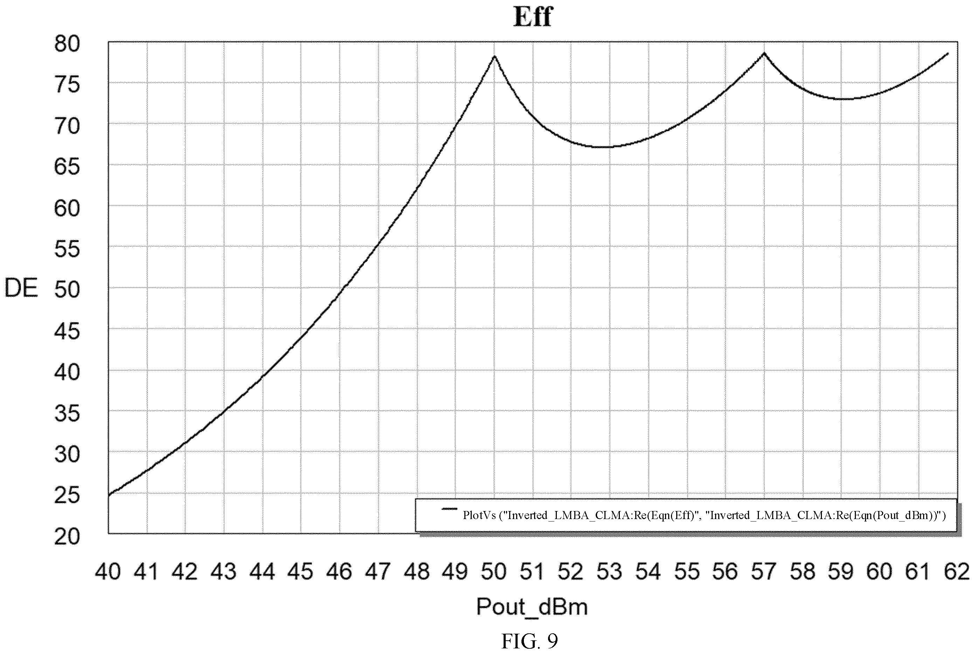

FIG. 9 is a diagram of an efficiency curve according to an embodiment of this application.

FIG. 9 shows efficiency Eff of a power amplifier device. In FIG. 9, a horizontal coordinate is output power of the power amplifier device, and a vertical coordinate is efficiency DE.

For example, three high-efficiency points of the power amplifier device provided in this embodiment appear at three power points respectively: full power 0 dB, a first power backoff point BO 1, and a second power backoff point BO 2. BO 1 and BO 2 are calculated as follows:

$$\text{BO } 2 = 10 \cdot \log_{10}^{(Psat_{main}/(Psat_{main}+2*Psat_{peak\,1}+Psat\_peak\,2))}$$

$$\text{BO } 1 = 10 \cdot \log_{10}^{((Psat_{main}+2*Psat_{peak\,1})/(Psat_{main}+2*Psat_{peak\,1}+Psat\_peak\,2))}$$

$Psat_{main}$ represents saturation power of Main, $Psat_{peak1}$ represents saturation power of Peak 1, and $Psat_{peak2}$ represents saturation power of Peak 2.

It is assumed that Main:Peak 1:Peak 1:Peak 2=100 W:200 W:200 W: 1000 W. In this case, BO 1=11.76, and BO 2=4.77 dB. The efficiency curve is shown in FIG. 9. The three high-efficiency points are generated at 61.77 dBm, 57 dBm, and 50 dBm respectively. To be specific, a position of a curve peak is the high-efficiency point, and a power backoff amount may reach 11.76 dB. In other words, the power backoff amount is large, and a pit is small.

The first power amplifier circuit in the power amplifier device described in the foregoing embodiment is implemented by the single-transistor power amplifier. The following describes implementation in which the first power amplifier circuit is implemented by a Doherty power amplifier. It should be understood that, in addition to the Doherty power amplifier, the first power amplifier circuit may also be implemented by a Chireix power amplifier, an LMBA power amplifier, or a CLMA power amplifier.

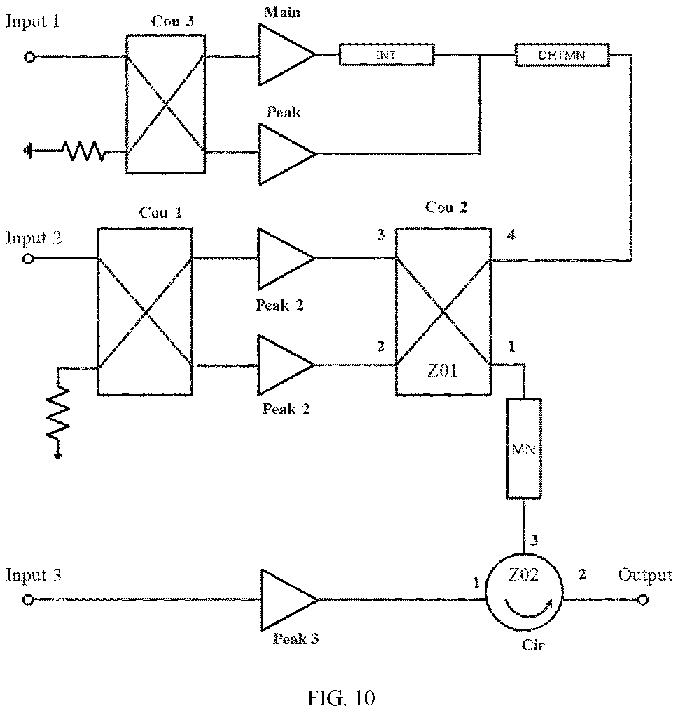

FIG. 10 is a schematic of another power amplifier device according to an embodiment of this application.

It can be learned by comparing FIG. 2 with FIG. 10 that Main in FIG. 2 is replaced by the Doherty (DHT for short) power amplifier, and other structures remain unchanged. Details are not described herein again.

The Doherty power amplifier includes a second coupler Cou 3, a carrier power amplifier Main, and a peak power amplifier Peak, and further includes an impedance inversion network INT and a matching network DHT_MN.

A first signal Input 1 is input to a first input port of the second coupler Cou 3, and a second input port of the second coupler Cou 3 is connected to a load. Power division is performed on the first signal by the second coupler Cou 3, and then divided signals are input to Main and Peak respectively. A signal output by Main is combined, after passing through INT, with a signal output by Peak, and then is input to an isolation port 4 of a first coupler Cou 2 through DHTMN.

In FIG. 10, Main works first, then Peak works, then two Peaks 1 work, and Peak 2 works last.

In this embodiment, the Doherty power amplifier is used to replace Main in FIG. 2, so that a design of a power amplifier architecture with ultra-large backoff. A backoff amount of the DHT power amplifier is increased in comparison with a backoff amount in FIG. 2. That is, a backoff amount is further increased.

Compared with the power amplifier device shown in FIG. 2, the power amplifier device shown in FIG. 10 may generate a plurality of high-efficiency points. In FIG. 2, three high-efficiency points may be generated. In FIG. 10, four high-efficiency points may be generated, so that a problem of a large pit during power backoff is further prevented.

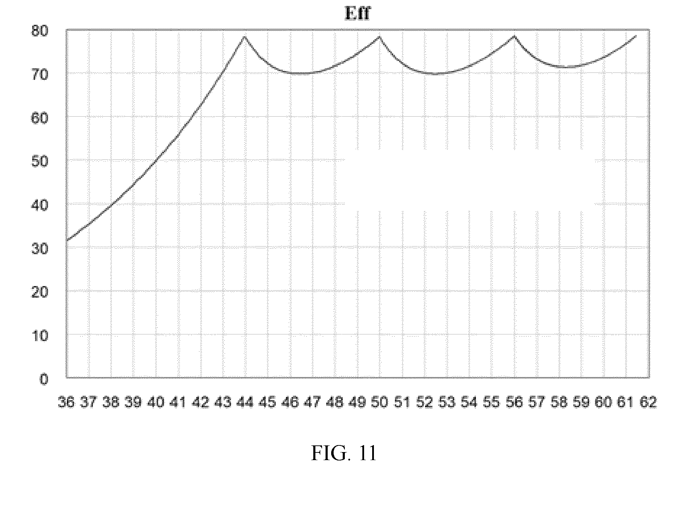

FIG. 11 is a diagram of an efficiency curve corresponding to FIG. 10.

In FIG. 11, a horizontal coordinate is output power Pout in a unit of dBm, and a vertical coordinate is efficiency DE.

For example, Main:Peak:Peak 2:Peak 2:Peak 3=50 W:50 W:200 W:200 W: 1000 W, the four high-efficiency points are generated at 61.77 dBm, 57 dBm, 50 dBm, and 44 dBm respectively, and backoff of 17.77 dB is implemented.

When output power is 44 dBm to 50 dBm, pulling is performed by DHT. When output power is 50 dBm to 57 dBm, pulling is performed by LMBA. When output power is 57 dBm to 61.77 dBm, pulling is performed by CLMA.

It should be understood that the power amplifier circuit connected to the isolation port of the first coupler Cou 2 may be independently disposed, and may be a single-transistor power amplifier, DHT, an asymmetric DHT, a three-way DHT, a four-way DHT, a Chireix power amplifier, an LMBA power amplifier, or a CLMA power amplifier. A corresponding wideband feature is further determined by a wideband feature of the independently disposed power amplifier circuit.

In the power amplifier devices described in the foregoing embodiments, final output signals are all combined by the circulator. The circulator is more suitable to be a final power combination component for a large-power scenario, and can resolve a power capacity problem of a large-power wideband power amplifier.

The following describes an implementation in which a final output signal is combined by a coupler.

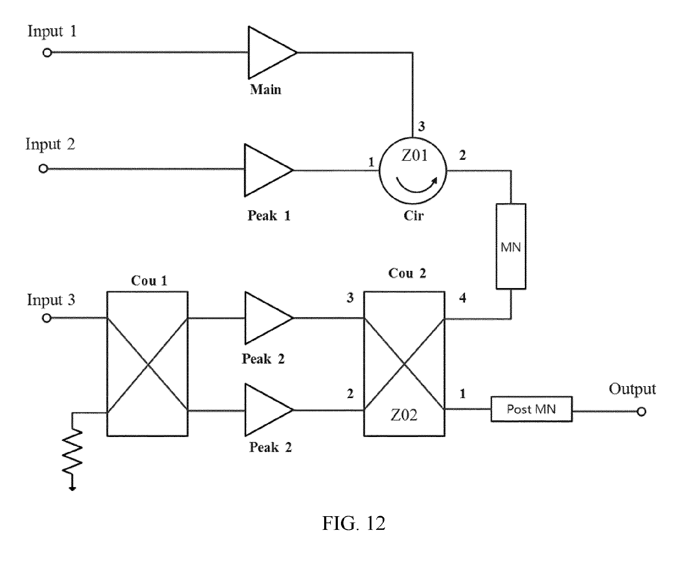

FIG. 12 is a schematic of still another power amplifier device according to an embodiment of this application.

According to the power amplifier device provided in this embodiment of this application, a circulator first combines two amplified signals, and then a coupler combines an output signal of the circulator and a third amplified signal, to finally output a signal obtained through power combination.

According to the power amplifier device provided in this embodiment of this application, a first power amplifier circuit is a single-transistor power amplifier, and the single-transistor power amplifier is biased in class AB or class B, and is referred to as a carrier power amplifier, that is, Main. A second power amplifier circuit includes a fourth amplification branch. A third power amplifier circuit includes a fifth amplification branch and a sixth amplification branch.

The fourth amplification branch is biased in shallow class C, and is represented by Peak 1. The fifth amplification branch and the sixth amplification branch are the same, and are both biased in deep class C, and therefore are represented by Peak 2.

A first signal Input 1 is input to an input end of the first power amplifier circuit Main, and an output end of the first power amplifier circuit Main is connected to an isolation port of a circulator Cir.

A second signal Input 2 is input to an input end of the fourth amplification branch Peak 1, an output end of the fourth amplification branch Peak 1 is connected to an input port of the circulator Cir, and an output port of the circulator Cir is connected to an isolation port of a first coupler Cou 2 through a matching circuit MN.

Impedance of the circulator Cir is Z01, and impedance of the first coupler Cou 2 is Z02. The matching circuit MN implements impedance conversion between Z01 and Z02, to implement impedance matching between the circulator Cir and the first coupler Cou 2.

A third signal Input 3 is input to a first input port of a second coupler Cou 1, and a second input port of the second coupler Cou 1 is connected to a load. Power division is performed on the third signal Input 3 by the second coupler Cou 1, and then divided signals are input to an input end of the fifth amplification branch Peak 2 and an input end of the sixth amplification branch Peak 2 respectively. An output end of the fifth amplification branch Peak 2 and an output end of the sixth amplification branch Peak 2 are respectively connected to two balanced ports of the first coupler Cou 2.

An output port of the first coupler Cou 2 outputs, through a matching circuit Post MN, the signal obtained through power combination.

The output port of the first coupler Cou 2 implements impedance conversion from Z02 to 50 ohms through the matching circuit Post MN.

When power is low, only Main works. Peak 1 does not work until Main is saturated. Main remains in a saturated state, and Peaks 2 do not work until Main and Peak 1 both reach saturation. Main and Peak 1 remain in the saturated state until Main, Peak 1, and Peaks 2 all reach saturation. Therefore, load modulation ratio of Main is 1. The power amplifier device provided in this embodiment may generate three high-efficiency points. The following provides detailed descriptions with reference to the diagram of the efficiency curve.

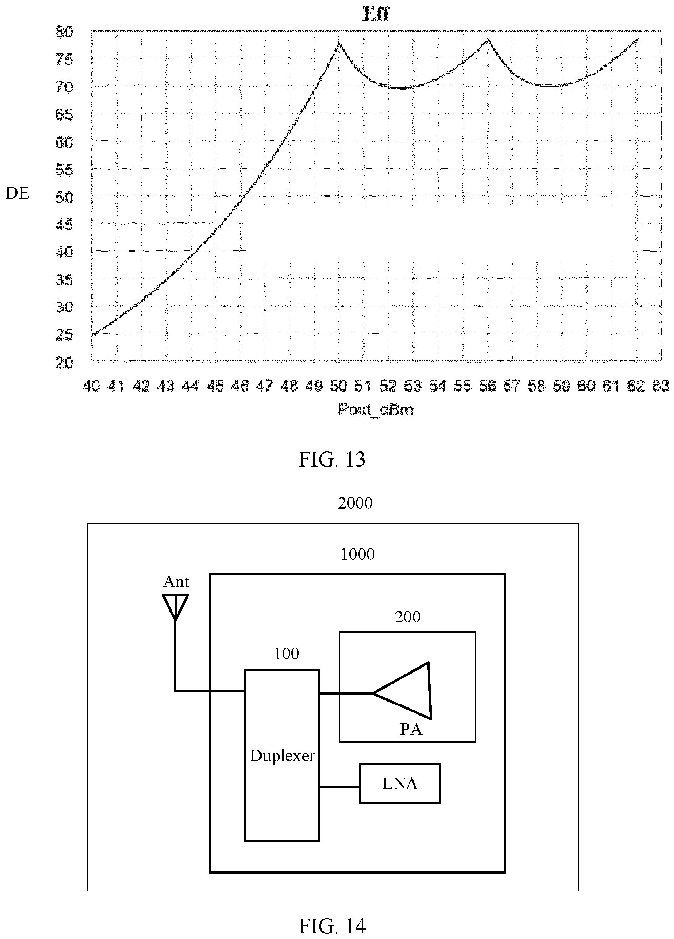

FIG. 13 is a diagram of an efficiency curve corresponding to FIG. 12.

For example, Main:Peak 1:Peak 2:Peak 2=100 W:300 W:600 W:600 W. As shown in FIG. 13, three high-efficiency points are generated at 62 dBm, 56 dBm, and 50 dBm respectively, and large backoff of 12 dB is implemented.

Similarly, in FIG. 12, in addition to the single-transistor power amplifier, the first power amplifier circuit may also be implemented by a DHT power amplifier, a Chireix power amplifier, an LMBA power amplifier, a CLMA power amplifier, or the like. A wideband feature further depends on a wideband feature of a power amplifier connected to the isolation port 3 of the circulator Cir.

Based on the power amplifier device provided in the foregoing embodiments, an embodiment of this application further provides a remote radio unit. For details, refer to FIG. 1. FIG. 1 is a schematic of a remote radio unit according to an embodiment of this application.

The remote radio unit provided in this embodiment includes the power amplifier device described in the foregoing embodiments, and further includes the duplexer 100.

One end of the power amplifier PA is connected to the duplexer 100. Specifically, the duplexer 100 is connected between the antenna Ant and the power amplifier PA of the base station, and the duplexer 100 is connected between the antenna Ant and the low noise amplifier LNA.

In addition, still refer to FIG. 1. The remote radio unit 1000 may further include the LNA, an ADC, and a DAC.

The remote radio unit provided in this embodiment of this application includes the power amplifier device described in the foregoing embodiments, which is applicable to input of up to three signals, and combines power through hybrid cascading of a coupler and a circulator. The coupler may be used as a last-stage power combination unit, or the circulator may be used as a last-stage power combination unit. The power amplifier device may generate at least three high-efficiency points. Because there are a plurality of high-efficiency points, a problem of an efficiency pit during large backoff can be alleviated. In addition, a working bandwidth of the power amplifier device depends on working bandwidths of a first power amplifier circuit, the coupler, and the circulator, so that ultra-wideband high-power signal processing can be implemented.

Based on the power amplifier device and the remote radio unit that are provided in the foregoing embodiments, an embodiment of this application further provides a base station. The following provides detailed descriptions with reference to the accompanying drawings.

FIG. 14 is a schematic of a base station according to an embodiment of this application.

An embodiment of this application further provides a base station 2000, including the remote radio unit 1000 described in the foregoing embodiment, and further including an antenna Ant.

The remote radio unit 1000 is connected to the antenna Ant.

The remote radio unit 1000 is configured to process a transmitted/received signal of the antenna Ant.

The base station provided in this embodiment of this application includes the power amplifier device 200 described in the foregoing embodiments, so that a plurality of high-efficiency points can be implemented, and a large pit during backoff can be alleviated. **In** addition, the base station is applicable to a high-power scenario, and can implement ultra-wideband high-power signal processing.

It should be understood that in this application, "at least one (item)" means one or more, and "a plurality of" means two or more. Therefore, any simple amendment or equivalent variation and modification made to the foregoing embodiments according to the technical essence of this application without departing from the content of the technical solutions of this application shall fall within the protection scope of the technical solutions of this application.

**Claims**

1. A power amplifier device, comprising a first power amplifier circuit, a second power amplifier circuit, a third power amplifier circuit, a first coupler, and a circulator, wherein

   an input end of the first power amplifier circuit is configured to connect to a first signal, an input end of the second power amplifier circuit is configured to connect to a second signal, both an output end of the first power amplifier circuit and an output end of the second power amplifier circuit are connected to an input port of the first coupler, and the first coupler is configured to output a signal obtained through power combination; and
   an input end of the third power amplifier circuit is configured to connect to a third signal, an output port of the first coupler and an output end of the third power amplifier circuit are connected to the circulator, and the circulator is configured to: combine power of a signal output by the third power amplifier circuit and the signal output by the first coupler, and then output a signal obtained through power combination.

2. A power amplifier device, comprising a first power amplifier circuit, a second power amplifier circuit, a third power amplifier circuit, a first coupler, and a circulator, wherein

   an input end of the first power amplifier circuit is configured to connect to a first signal, an input end of the second power amplifier circuit is configured to connect to a second signal, both an output port of the first power amplifier circuit and an output end of the second power amplifier circuit are connected to the circulator, and the circulator is configured to output a signal obtained through power combination; and
   an input end of the third power amplifier circuit is configured to connect to a third signal, an output port of the circulator and an output end of the third power amplifier circuit are connected to the first coupler, and the first coupler is configured to: combine power of a signal output by the third power amplifier circuit and the signal output by the circulator, and then output a signal obtained through power combination.

3. The power amplifier device according to claim 1, wherein the second power amplifier circuit comprises a first amplification branch and a second amplification branch, and the third power amplifier circuit comprises a third amplification branch;

the first amplification branch and the second amplification branch are the same, and are both biased in shallow class C; and
the third amplification branch is biased in deep class C.

4. The power amplifier device according to claim 3, wherein the first power amplifier circuit is a single-transistor power amplifier, and the single-transistor power amplifier is a carrier power amplifier when biased in class AB or class B; and further comprises a second coupler and a matching circuit;

an input end of the carrier power amplifier is configured to input the first signal, and an output end of the carrier power amplifier is connected to an isolation port of the first coupler;
a first input port of the second coupler is configured to input the second signal, and a second input port of the second coupler is connected to a load; the first input port of the second coupler is configured to connect to the second signal, and the second input port of the second coupler is configured to connect to the load; and two output ports of the second coupler are respectively connected to an input end of the first amplification branch and an input end of the second amplification branch, and an output end of the first amplification branch and an output end of the second amplification branch are respectively connected to two balanced ports of the first coupler;
the output port of the first coupler is connected to a first end of the matching circuit, and a second end of the matching circuit is connected to an isolation port of the circulator; and
an input end of the third amplification branch is configured to input the third signal, an output end of the third amplification branch is connected to an input port of the circulator, and an output port of the circulator is configured to output a signal obtained by combining power of signals of the isolation port and the input port.

5. The power amplifier device according to claim 3 or 4, wherein a load-pull ratio of the first power amplifier circuit is 1.

6. The power amplifier device according to claims 3 to 5, further comprising: a first power division circuit and a first phase compensation network, wherein
the first power division circuit is configured to output the first signal and the second signal, one end that is of the first power division circuit and that outputs the first signal is connected to an input end of the first phase compensation network, an output end of the first phase compensation network is connected to the input end of the carrier power amplifier, and one end that is of the first power division circuit and that outputs the second signal is connected to the first input port of the second coupler.

7. The power amplifier device according to claim 6, further comprising: a second power division circuit and a second phase compensation network, wherein

two output ends of the second power division circuit are respectively connected to an input end of the first power division circuit and an input end of the second phase compensation network; and
an output end of the second phase compensation network is connected to the input end of the third amplification branch.

8. The power amplifier device according to claim 2, wherein the first power amplifier circuit is a single-transistor power amplifier, the single-transistor power amplifier is a carrier power amplifier when biased in class AB or class B, the second power amplifier circuit comprises a fourth amplification branch, and the third power amplifier circuit comprises a fifth amplification branch and a sixth amplification branch; and
the fourth amplification branch is biased in shallow class C, the fifth amplification branch and the sixth amplification branch are the same, and are both biased in deep class C.

9. The power amplifier device according to claim 2, further comprising: a second coupler, a first matching circuit, and a second matching circuit, wherein

the input end of the first power amplifier circuit is configured to input the first signal, and the output end of the first power amplifier circuit is connected to an isolation port of the circulator;

an input end of the fourth amplification branch is configured to connect to the second signal, an output end of the fourth amplification branch is connected to an input port of the circulator, an output port of the circulator is connected to a first end of the first matching circuit, and a second end of the first matching circuit is connected to an isolation port of the first coupler;

a first input port of the second coupler is configured to input the third signal, and a second input port of the second coupler is connected to a load; the first input port of the second coupler is configured to connect to the third signal, and the second input port of the second coupler is configured to connect to the load; and an input end of the fifth amplification branch and an input end of the sixth amplification branch are respectively connected to two output ports of the second coupler, and an output end of the fifth amplification branch and an output end of the sixth amplification branch are respectively connected to two balanced ports of the first coupler; and

an output port of the first coupler is connected to a first end of the second matching circuit, and an output port of the second matching circuit is configured to output a signal obtained through power combination.

10. The power amplifier device according to claim 1 or 2, wherein the first power amplifier circuit comprises any one of the following: a Doherty power amplifier, a Chireix power amplifier, an LMBA power amplifier, or a CLMA power amplifier.

11. The power amplifier device according to any one of claims 1 to 4, wherein the first power amplifier circuit works first, the second power amplifier circuit works later, and the third power amplifier circuit works last.

12. A remote radio unit, comprising the power amplifier device according to any one of claims 1 to 11, and further comprising a duplexer, wherein
one end of the power amplifier device is connected to the duplexer.

13. A base station, comprising the remote radio unit according to claim 12, and further comprising an antenna, wherein

the remote radio unit is connected to the antenna; and
the remote radio unit is configured to process a transmitted/received signal of the antenna.

Ant

1000

200

100

Duplexer

PA

LNA

FIG. 1

FIG. 2

**Current**

FIG. 3

**Voltage**

FIG. 4

FIG. 5

FIG. 6

FIG. 7

EP 4 583 470 A1

FIG. 8

FIG. 9

EP 4 583 470 A1

FIG. 10

FIG. 11

FIG. 12

FIG. 13

FIG. 14

## INTERNATIONAL SEARCH REPORT

| International application No. |
| --- |
| **PCT/CN2022/125795** |

**A. CLASSIFICATION OF SUBJECT MATTER**

H04L 27/00(2006.01)i

According to International Patent Classification (IPC) or to both national classification and IPC

**B. FIELDS SEARCHED**

Minimum documentation searched (classification system followed by classification symbols)

IPC: H04W, H04L

Documentation searched other than minimum documentation to the extent that such documents are included in the fields searched

Electronic data base consulted during the international search (name of data base and, where practicable, search terms used)

CNTXT, ENTXT, WPABS, CNKI, 3GPP: 功放, 功率放大电路, 射频拉远单元, 带宽, 频谱, 宽带, 波形, 波峰, 削减, 峰值, 平均, 功率比, 瞬时, 补偿, 饱和, 射频, 天线, power amplification, remote radio unit, RRU, bandwidth, spectrum, broadband, waveform, peak, clip, peak, average, power ratio, instantaneous, compensation, saturation, radio frequency, antenna

**C. DOCUMENTS CONSIDERED TO BE RELEVANT**

| Category* | Citation of document, with indication, where appropriate, of the relevant passages | Relevant to claim No. |
| --- | --- | --- |
| Y | US 2022255506 A1 (UNIVERSITY OF CENTRAL FLORIDA RESEARCH FOUNDATION, INC.) 11 August 2022 (2022-08-11) description, paragraphs 90-114 | 1-13 |
| Y | CN 213879768 U (LEIHUA ELECTRONIC TECHNOLOGY RESEARCH INSTITUTE, AVIATION INDUSTRY CORPORATION OF CHINA) 03 August 2021 (2021-08-03) description, paragraphs 17-29 | 1-13 |
| A | CN 101534093 A (WUHAN GEWEI ELECTRONIC TECHNOLOGY CO., LTD.) 16 September 2009 (2009-09-16) entire document | 1-13 |
| A | CN 111740703 A (HANGZHOU DIANZI UNIVERSITY) 02 October 2020 (2020-10-02) entire document | 1-13 |
| A | CN 114513173 A (TSINGHUA UNIVERSITY et al.) 17 May 2022 (2022-05-17) entire document | 1-13 |

☑ Further documents are listed in the continuation of Box C.   ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **26 June 2023** | **27 June 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2022/125795** |

**C.    DOCUMENTS CONSIDERED TO BE RELEVANT**

| Category* | Citation of document, with indication, where appropriate, of the relevant passages | Relevant to claim No. |
| --- | --- | --- |
| A | US 2016226450 A1 (MITSUBISHI ELECTRIC RESEARCH LABORATORIES, INC.) 04 August 2016 (2016-08-04) entire document | 1-13 |

Form PCT/ISA/210 (second sheet) (July 2022)

**EP 4 583 470 A1**

**INTERNATIONAL SEARCH REPORT**
Information on patent family members

International application No.

**PCT/CN2022/125795**

| Patent document cited in search report | | | Publication date (day/month/year) | Patent family member(s) | | | Publication date (day/month/year) |
|---|---|---|---|---|---|---|---|
| US | 2022255506 | A1 | 11 August 2022 | None | | | |
| CN | 213879768 | U | 03 August 2021 | None | | | |
| CN | 101534093 | A | 16 September 2009 | EP | 2312746 | A1 | 20 April 2011 |
| | | | | EP | 2312746 | A4 | 11 June 2014 |
| | | | | EP | 2312746 | B1 | 15 March 2017 |
| | | | | WO | 2010118645 | A1 | 21 October 2010 |
| | | | | ES | 2626654 | T3 | 25 July 2017 |
| | | | | US | 2011080215 | A1 | 07 April 2011 |
| | | | | US | 8324965 | B2 | 04 December 2012 |
| CN | 111740703 | A | 02 October 2020 | None | | | |
| CN | 114513173 | A | 17 May 2022 | None | | | |
| US | 2016226450 | A1 | 04 August 2016 | KR | 20170109019 | A | 27 September 2017 |
| | | | | KR | 101946187 | B1 | 08 February 2019 |
| | | | | US | 9503028 | B2 | 22 November 2016 |
| | | | | JP | 2017516416 | A | 15 June 2017 |
| | | | | JP | 6184614 | B2 | 23 August 2017 |
| | | | | WO | 2016121306 | A1 | 04 August 2016 |
| | | | | GB | 201711237 | D0 | 23 August 2017 |
| | | | | GB | 2549886 | A | 01 November 2017 |
| | | | | GB | 2549886 | B | 16 June 2021 |

Form PCT/ISA/210 (patent family annex) (July 2022)